# DEMANDE DE BREVET EUROPEEN

(11) **EP 1 017 195 A1**
(43) Date de publication de la demande: **05.07.2000**
(21) Numéro de dépôt: 99470021.9
(22) Date de dépôt: 12.11.1999
(51) Int. Cl.: H04L 1/00, G06K 19/07

(54) **Circuit générateur de signature**

(30) Priorité: 30.11.1998 FR 9815249
(71) Demandeur: STMicroelectronics SA, 94250 Gentilly Cedex (FR)
(72) Inventeur: Jain, Manish, 57000 Metz (FR)
(74) Mandataire: Ballot, Paul Denis Jacques

(57) **Abrégé**

L'invention a pour but de fournir un circuit générateur de signature 22 de petite dimension et de faible consommation, et qui ne tient pas compte dans sa structure du nombre de mots nécessaire pour la signature. Le circuit générateur de signature 22 de l'invention comporte une porte logique 30, recevant en série sur l'une de ses entrées une pluralité de mots DIN, et un registre à décalage 31, une entrée dudit registre 31 étant reliée à la sortie de la porte logique 30, et la sortie étant reliée à l'autre entrée de ladite porte 30. L'invention dévoile également un procédé de génération de signature relatif à une pluralité de mots à l'aide du circuit 22.

## Description

L'invention concerne un circuit générateur de signature pour contrôler la validité de données. Plus particulièrement, l'invention se rapporte aux circuits intégrés utilisés dans des transpondeurs.

Le principe des transpondeurs à circuits intégrés consiste à contrôler, à l'aide d'un lecteur, le transpondeur et/ou à laisser une trace dans le transpondeur en ayant une manipulation minimum (il suffit que le transpondeur soit à proximité d'un lecteur). Généralement, les transpondeurs sont des objets de petites dimensions (badge au format carte de crédit, étiquette ou clef de voiture) et il ne sont pas munis d'une source d'alimentation autonome.

Pour fonctionner, ils sont munis d'une petite antenne qui capte un champ magnétique modulé. Un circuit intégré connecté à deux bornes de l'antenne va d'une part produire une tension d'alimentation à partir de ce champ magnétique et d'autre part démoduler et/ou moduler le champ magnétique pour communiquer avec le lecteur.

Différents problèmes apparaissent sur les circuits intégrés destinés à être utilisés dans les transpondeurs. Les circuits intégrés doivent être de petite dimension pour pouvoir être placés dans différents objets sans être détruits par déformation mécanique de l'objet dans lequel ils sont placés. La consommation des circuits intégrés doit être réduite au minimum car l'énergie récupérée aux bornes de l'antenne est limitée.

Un problème plus important provient de la transmission des données. En effet, les données sont modulés sur le champ magnétique qui peut être plus ou moins bruité. Par ailleurs, les contraintes de taille et de consommation du circuit intégré utilisé ne permettent pas d'avoir un dispositif correcteur d'erreur complexe. Il est connu d'utiliser un double contrôle de parité. Le double contrôle de parité consiste à contrôler la parité de chaque mot transmis et à contrôler, sur un certain nombre de mots transmis successivement, une signature de parité.

L'invention a pour but de fournir un circuit générateur de signature de petite dimension et de faible consommation. Le circuit de l'invention a également pour avantage de ne pas tenir compte dans sa structure du nombre de mots à prendre en compte dans le contrôle de parité ; il peut ainsi produire une signature sur un nombre de mots variable.

L'invention a pour objet un circuit générateur de signature pour produire un mot relatif à une pluralité de mots caractérisé en ce qu'il comporte une porte logique à deux entrées et une sortie, ladite porte logique recevant en série sur l'une de ses entrées la pluralité de mots, et un registre à décalage comportant une entrée de donnée, une entrée d'horloge et une sortie, l'entrée d'horloge recevant un signal d'horloge qui cadence la pluralité de mots, l'entrée de donnée étant reliée à la sortie de la porte logique, et la sortie étant reliée à l'autre entrée de ladite porte logique.

L'invention a également pour objet un procédé de génération de signature relatif à une pluralité de mots à l'aide d'une porte logique et d'un registre à décalage, ledit procédé comportant les étapes de:
- initialisation à zéro d'un contenu du registre à décalage,
- fourniture en série, sur une première entrée de la porte logique, d'un mot de la pluralité de mots et, sur la deuxième entrée, du mot contenu dans le registre à décalage, le mot sortant de la porte logique étant stocké dans le registre à décalage,
- répétition de l'étape précédente, de manière successive, pour chaque autre mot de la pluralité de mots,
- récupération d'un mot de signature présent dans le registre à décalage.

L'invention sera mieux comprise et d'autres particularités et avantages apparaîtront à la lecture de la description qui va suivre, la description faisant référence aux dessins annexés parmi lesquels:
la figure 1 représente schématiquement un circuit intégré utilisé dans une application sans contact,
la figure 2 représente schématiquement un circuit de gestion de protocole selon l'invention,
la figure 3 représente schématiquement un circuit générateur de signature selon l'invention,
la figure 4 représente une variante du circuit de la figure 3.

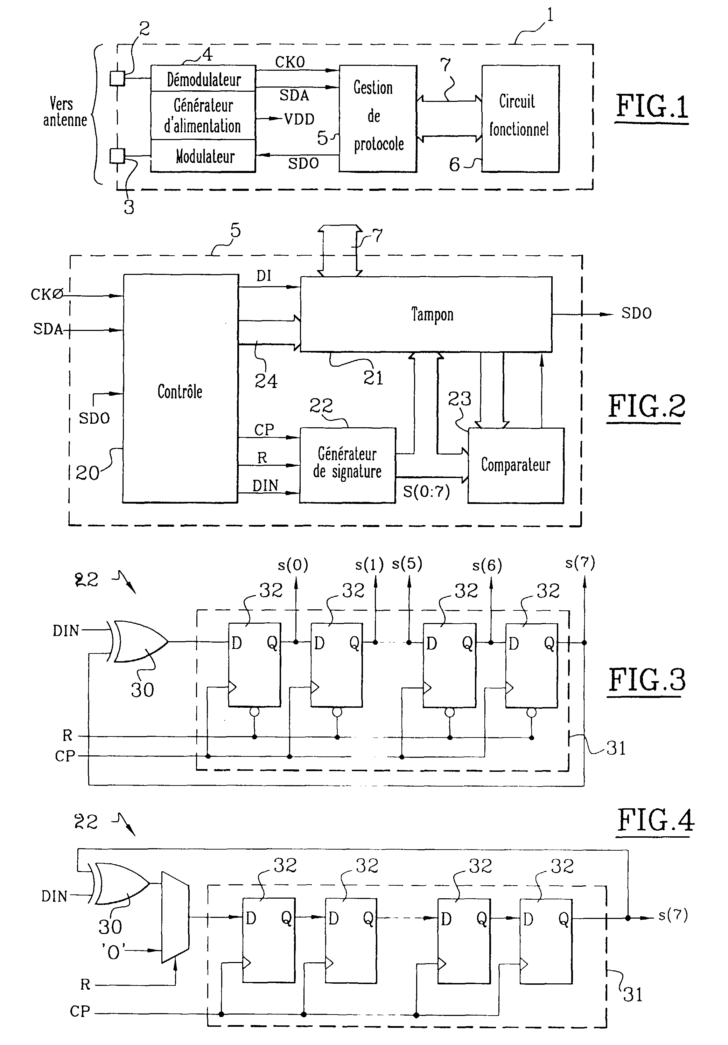

Le schéma de la figure 1 représente un circuit intégré 1 destiné à être utilisé dans un dispositif sans contact. Le circuit intégré 1 comporte deux bornes 2 et 3 de connexion pour communiquer avec l'extérieur. Généralement, les deux bornes 2 et 3 sont connectées à une antenne (non représentée).

Pour expliquer l'invention, on a décomposé le circuit intégré 1 en un circuit d'entrée 4, un circuit de gestion de protocole 5 et un circuit fonctionnel 6. Le circuit d'entrée 4 est connecté aux deux bornes 2 et 3 et assure d'une part une fonction de circuit d'alimentation du circuit intégré 1 en fournissant une tension d'alimentation VDD à l'ensemble du circuit intégré 1, et d'autre part une fonction de modulateur et de démodulateur.

La fonction démodulateur permet d'extraire, à partir des signaux provenant des bornes 2 et 3, un signal d'horloge CK0 qui va être utilisé pour la gestion du circuit intégré 1 et un signal SDA de flot de donnée lorsque des données sont reçues. La fonction modulateur reçoit un signal SDO de donnée à émettre et module, en fonction du signal SDO, la porteuse du signal reçu par l'antenne pour émettre les données contenues dans le signal SDO.

Le circuit de gestion de protocole 5 reçoit le signal d'horloge CK0 et le signal SDA, puis il vérifie que les données sont correctement reçues, il renvoie ensuite un signal de bonne (et/ou de mauvaise) réception lors de la réception d'un bloc de donnée et le transmet au circuit fonctionnel 6 par l'intermédiaire d'un bus 7.

Le circuit fonctionnel 6 peut être n'importe quel type de circuit adapté à une application particulière. A titre d'exemple, on peut considérer que le circuit fonctionnel 6 est une mémoire 8 bits de type EEPROM disposant d'un jeu d'instructions d'un type classique, par exemple: lecture d'une adresse, écriture à une adresse, lecture par page, protection de la mémoire, etc... Le bus 7 correspond aux bus classiques d'adresses, de données, et de commande d'une mémoire.

Le circuit de gestion de protocole 5 va servir d'interface entre le bus 7 et l'extérieur. Pour cela, on utilise un protocole de type esclave dans lequel le circuit intégré va recevoir, par exemple, un mot d'instruction éventuellement suivi d'un ou plusieurs mots d'adresse et/ou d'un ou plusieurs mots de donnée. Chaque transmission d'instruction, comportant éventuellement une ou plusieurs adresses et/ou une ou plusieurs données, est suivie d'un mot de signature qui permet de contrôler l'intégrité des mots transmis. Par ailleurs, à chaque mot transmis correspond une trame de transmission qui comporte un bit de début de trame correspondant au mot à transmettre, deux bits de type pour indiquer si le mot transmis est une instruction, une adresse, une donnée ou une signature, et un bit de parité de trame.

Lors de la réception de l'instruction complète, le circuit intégré va envoyer un mot de bonne ou de mauvaise réception après vérification de la parité de chaque trame et vérification de la signature. Lorsqu'une lecture est demandée au circuit intégré, celui-ci va renvoyer un ou plusieurs mots de données (lecture simple ou par page) suivi d'un mot de signature en utilisant des trames du même type.

Comme peut s'en apercevoir l'homme du métier, suivant l'instruction envoyée, le nombre de mots à prendre en compte pour la signature peut être variable en fonction de l'instruction.

La figure 2 représente schématiquement le circuit de gestion de protocole 5. Le circuit de gestion de protocole 5 comporte un circuit de contrôle 20, un circuit tampon 21, un circuit générateur de signature 22 et un comparateur 23.

Le circuit de contrôle 20 vérifie l'intégrité d'une trame, décode la trame et fournit le mot contenu dans la trame au circuit tampon 21 et au circuit générateur de signature 22 avec des signaux de commande appropriés. Le circuit de contrôle 20 dispose pour cela d'une première entrée recevant le signal d'horloge CK0, d'une deuxième entrée recevant le signal SDA, et d'une troisième entrée recevant le signal SDO qui est produit par le circuit tampon 21. Le circuit de contrôle 20 dispose par ailleurs d'un bus de commande 24 pour fournir, au circuit tampon 21, différents signaux qui identifient les données reçues comme étant des instructions, des adresses, des données ou des signatures. Le bus de commande 24 transmet également des signaux de synchronisation notamment pour pouvoir émettre des données ou envoyer des messages de bonne (ou mauvaise) réception. Le circuit de contrôle 20 fournit également au circuit tampon 21 un signal DI qui correspond à la transmission en série des bits constituant les mots reçus. Le circuit de contrôle 20 fournit au circuit générateur de signature 22 un signal d'horloge CP, un signal de remise à zéro R et un signal de donnée DIN qui seront détaillés par la suite.

Le circuit tampon 21 est essentiellement constitué de registres à décalage disposant d'entrées et sorties série ainsi que d'entrées et sorties parallèles. Les données, reçues du circuit de contrôle 20 par l'intermédiaire du signal SDO, sont stockées dans un registre à décalage qui correspond au type de données (adresse, donnée, instruction, signature) pour être ensuite fournies sur le bus 7 en parallèle. Par ailleurs, les données contenues dans les registres peuvent être fournies en série par l'intermédiaire du signal SDO afin d'être modulées. Le circuit tampon 21 comporte par ailleurs une entrée de signature S(0:7) reliée à la sortie du circuit générateur de signature 22 pour stocker une signature correspondant aux données transmises et une sortie de signature pour fournir au comparateur 23 la signature reçue pour pouvoir la comparer à la signature calculée par le générateur de signature 22 pour les mots précédemment reçus. Une entrée de signal de validité permet au circuit tampon de savoir si le résultat de la comparaison est valide ou pas. Le circuit tampon 21 est également muni de deux registres non volatils contenant respectivement un message de bonne réception et un message de mauvaise réception qu'il peut fournir par l'intermédiaire du signal SDO, le signal de mauvaise réception étant fourni si le circuit de contrôle 20 signale une erreur de parité de trame ou si le comparateur 23 indique une mauvaise comparaison.

Deux exemples de réalisation préférées du circuit générateur de signature 22 sont décrits sur les figures 3 et 4. Le circuit générateur de signature 23 est constitué d'une porte logique 30, par exemple de type OU-EXCLUSIF, à deux entrées et une sortie, ladite porte logique 30 recevant en série sur l'une de ses entrées le signal DIN, et d'un registre 31 à décalage comportant une entrée série, une entrée d'horloge et une sortie série, l'entrée d'horloge recevant le signal d'horloge CP qui cadence la pluralité de mots, l'entrée série étant reliée à la sortie de la porte logique 30, et la sortie série étant reliée à l'autre entrée de ladite porte 30.

Sur la figure 3, le registre à décalage 31 est constitué de huit bascules 32 de type D à remise à zéro asynchrone. Les entrées de remise à zéro des bascules 32 sont connectées ensemble pour former une entrée de remise à zéro asynchrone pour le registre 31, ladite entrée de remise à zéro asynchrone recevant le signal R. Par ailleurs la sortie de chacune des bascules S(0) à S(7) constitue une sortie parallèle S(0:7) du registre 31. La sortie parallèle S(0:7) permet de sortir le mot contenu dans ledit registre.

Le fonctionnement du circuit générateur 23 de la figure 3 est le suivant. Le circuit de contrôle 20 envoie une impulsion de remise à zéro sur le signal R afin d'initialiser à zéro toutes les bascules 32 du registre 31. Lorsque une trame est vérifiée par le circuit de contrôle et s'il s'agit d'une instruction d'une adresse ou d'une donnée, le circuit de contrôle fournit en série le mot contenu dans la trame par l'intermédiaire du signal DIN cadencé par le signal d'horloge CP. Le décalage successif des mots d'instruction, d'adresse et de donnée reçus dans le circuit a pour effet d'effectuer un OU-EXCLUSIF bit à bit entre les différents mots. Lorsque le mot de signature est reçu par le circuit de contrôle 20, un mot de signature est déjà présent dans le registre 31. Le circuit de contrôle 20 fournit alors le mot de signature reçu au circuit tampon 21 puis une comparaison est effectuée, dans le comparateur 23 avec la signature contenue dans le registre 31 qui est fournie par la sortie parallèle S(0:7).

Lorsque des données sont émises par le circuit intégré 1, le circuit de contrôle émet une impulsion sur le signal R pour remettre à zéro le registre 31, puis le circuit tampon 21 émet la ou les trames correspondant au(x) mot(s) de données à transmettre sur le signal SDO sous le contrôle du circuit de contrôle 20. Le circuit de contrôle 20 décode les trames et fournit les mots au circuit générateur 22 de manière successive. Lorsque la totalité des mots a été émise, la signature présente dans le registre 31 est transmise dans le circuit tampon pour être émise sous forme de trame.

L'utilisation de ce circuit générateur 23 permet de s'affranchir du nombre de mots à transmettre permettant de ce fait d'avoir une structure non spécifique à un nombre de mot. Cette structure permet également de gagner de la place en terme de surface car il n'est pas nécessaire d'avoir recours à huit dispositifs de calcul de parité en parallèle sur les registres des mots reçus ou à transmettre.

La figure 4 présente une variante de l'invention dans laquelle la sortie du mot de signature se fait en série. Le circuit générateur 23 diffère car le registre 31 ne dispose pas de sortie parallèle ni d'entrée de remise à zéro. Le circuit générateur 23 comporte cependant un multiplexeur 33 à deux entrées et une sortie, l'une des entrées étant connectée à la sortie de la porte logique 30 et la sortie étant connectée à l'entrée série du registre 31, l'autre entrée du multiplexeur 33 recevant un zéro logique. Une entrée de sélection du multiplexeur 33 reçoit le signal R.

Le fonctionnement du circuit générateur de la figure 4 diffère pour ce qui est de l'initialisation du registre 31 et de la récupération de la signature contenue dans le registre. En effet, parallèlement à la sortie en série du mot de signature le signal R est activé de manière à propager un zéro dans le registre 31 afin de l'initialiser pour le prochain calcul de signature.

Le circuit de la figure 4 présente comme avantage par rapport au circuit de la figure 3 une réduction de taille du circuit tampon 21 et du comparateur 23. En effet, on peut se contenter d'avoir un comparateur série de taille moins encombrante qu'un comparateur parallèle, et il n'est plus nécessaire d'avoir un registre dans le circuit tampon 21 pour mémoriser la signature avant la comparaison ou avant la transmission. Toutefois le circuit de la figure 4 a besoin d'une séquence de remise à zéro lors de la mise sous tension du circuit intégré 1 qui peut être gênante dans certaines applications.

De nombreuses variantes sont à la portée de l'homme du métier sans toutefois s'éloigner de l'objet de l'invention.

La porte logique 31 est ici représentée comme une porte logique de type OU-EXCLUSIF mais on aurait très bien pu utilisé un autre type de porte, par exemple une porte de type OU-NON-EXCLUSIF.

Le registre 30 est dans l'exemple constitué de huit bascules de type D pour pouvoir contenir des mots de huit bits. Il va de soi que l'on peut transmettre des mots d'une taille supérieure à huit bits, dans ce cas là, on utilisera un registre 30 comprenant un nombre de bascules supérieur à huit.

## Revendications

1. Circuit générateur de signature (22) pour produire un mot relatif à une pluralité de mots caractérisé en ce qu'il comporte:
- une porte logique (30) à deux entrées et une sortie, ladite porte recevant en série sur l'une de ses entrées la pluralité de mots (DIN),
- un registre à décalage (31) comportant une entrée de donnée, une entrée d'horloge et une sortie, l'entrée d'horloge recevant un signal d'horloge (CP) qui cadence la pluralité de mots, l'entrée de donnée étant reliée à la sortie de la porte logique (30), et la sortie étant reliée à l'autre entrée de ladite porte (30).

2. Circuit selon la revendication 1, caractérisé en ce que le registre à décalage (31) comporte une sortie parallèle pour sortir le mot contenu dans ledit registre (31).

3. Circuit selon l'une des revendications 1 ou 2, caractérisé en ce que le registre à décalage (31) comporte une entrée de remise à zéro asynchrone pour mettre à zéro le contenu dudit registre à l'aide d'une impulsion.

4. Circuit selon la revendication 1, caractérisé en ce qu'il comporte un multiplexeur (33) à deux entrées et une sortie, l'une des entrées étant connectée à la sortie de la porte logique (30) et la sortie étant connectée à l'entrée de donnée du registre à décalage (31), l'autre entrée du multiplexeur (33) recevant un zéro logique.

5. Circuit selon l'une des revendications 1 à 4, caractérisé en ce que la porte logique (30) est une porte de type OU-EXCLUSIF.

6. Circuit intégré (1) pour dispositif sans contact comprenant un circuit de gestion de protocole (5) déterminant une signature sur une pluralité de mots, caractérisé en ce qu'il comporte le circuit (22) de l'une des revendications 1 à 5.

7. Procédé de génération de signature relatif à une pluralité de mots à l'aide d'une porte logique (30) et d'un registre à décalage (31), ledit procédé comportant les étapes de:
- initialisation à zéro d'un contenu du registre à décalage (31),
- fourniture en série, sur une première entrée de la porte logique (30), d'un mot de la pluralité de mots (DIN) et, sur la deuxième entrée, du mot contenu dans le registre à décalage (31), le mot sortant de la porte logique (30) étant stocké dans le registre à décalage (31),
- répétition de l'étape précédente, de manière successive, pour chaque autre mots de la pluralité de mots,
- récupération d'un mot de signature présent dans le registre à décalage (31).

8. Procédé selon la revendication 7, caractérisé en ce que l'initialisation du registre (31) se fait de manière asynchrone et en ce que la récupération de la signature se fait par une sortie parallèle (S(0:7)) du registre à décalage (31).

9. Procédé selon la revendication 7, caractérisé en ce que l'initialisation du registre (31) se fait par propagation d'un zéro dans le registre à décalage (31), et en ce que, la récupération de la signature se fait en série.

10. Procédé selon l'une des revendications 7 à 9, caractérisé en ce que la porte logique (30) est une porte de type OU-EXCLUSIF.
